Europäisches Patentamt

European Patent Office

Office européen des brevets

(11) Veröffentlichungsnummer: **0 351 531**

**A2**

# (12) EUROPÄISCHE PATENTANMELDUNG

(21) Anmeldenummer: **89110182.6**

(22) Anmeldetag: **06.06.89**

(51) Int. Cl.⁴: **H01L 23/538 , H01L 23/14**

(30) Priorität: **20.07.88 DE 3824654**

(43) Veröffentlichungstag der Anmeldung:
**24.01.90 Patentblatt 90/04**

(84) Benannte Vertragsstaaten:
**DE FR GB**

(71) Anmelder: **International Business Machines
Corporation
Old Orchard Road
Armonk, N.Y. 10504(US)**

(72) Erfinder: **Gruber, H. W.
Wikingerstrasse 3
D-7033 Herrenberg(DE)**
Erfinder: **Stadler, E.E., Dipl.-Ing. (FH)
Taunussstrasse 48
D-7033 Herrenberg(DE)**
Erfinder: **Hinrichsmeyer, K.
Tessiner Strasse 28
D-7032 Sindelfingen 7(DE)**
Erfinder: **Horbach, H. G.
Calwerstrasse 26
D-7268 Gechingen(DE)**

(74) Vertreter: **Dreiss, Hosenthien & Fuhlendorf
Gerokstrasse 6
D-7000 Stuttgart 1(DE)**

(54) Elektronische Baueinheit.

(57) Die elektronische Baueinheit (11) besitzt ein Substrat (12), auf dem mehrere Chips (13) angeordnet sind, und eine Vielzahl von Verbindungsstiften (26), die an einer Stiftplatte (21-24) gehalten und über Leiter mit den Chips (13) elektrisch verbunden sind. Dabei sind mehrere mit Verbindungsstiften (26) versehene Stiftplatten (21-24) vorgesehen, von denen jede mittels mindestens eines mit den Leitern versehenen, flexiblen Verbindungselementes (29) an einem Randbereich (16-19) des eine Grundfläche in Form eines beliebigen Vielecks aufweisenden Substrats (12) derart gehalten ist, daß sie aus einer mit der Ebene des Substrats (12) im wesentlichen fluchtenden Ebene in eine Position unterhalb des Substrats (12) bzw. umgekehrt klappbar ist. Dadurch ist eine elektronische Baueinheit geschaffen, die weniger aufwendig in der Herstellung ist und die bei vergleichbarer Leistungsfähigkeit eine erheblich geringere Grundfläche einnimmt.

FIG.1

## Elektronische Baueinheit

Die vorliegende Erfindung bezieht sich auf eine elektronische Baueinheit, wie sie auch unter dem Begriff Modul bekannt ist, nach dem Oberbegriff des Anspruchs 1.

Bei einer derartigen Baueinheit bzw. Modul, wie er aus IEEE Transactions on Components, Hybrids and Manufacturing Technology, Vol.CHMT-7, No. 2, S. 193 ff., Juni 1984 bekannt geworden ist, ist das mit mehreren integrierte Schaltkreise aufweisenden Chips versehene Substrat aus Silizium auf einer flächengrößeren Platte aus Keramik etwa mittig aufgebracht. Diese Keramikplatte besitzt randseitig die Verbindungsstifte welche über auf der Keramikplatte vorhandene Leiterbahnen mit den Verbindungsstellen der Chips auf dem Siliziumsubstrat verbunden sind.

Ein derartiges Modul ist, da es aus mehreren zunächst unzusammenhängenden Teilen besteht die anschließend miteinander verbunden werden müssen in der Herstellung relativ aufwendig. Dies nicht nur deshalb, weil das die Chips tragende Substrat und die mit den Verbindungsstiften bestückte Platte in verschiedenen Fertigungslinien getrennt hergestellt werden müssen sondern auch weil eine gewisse Schwierigkeit darin besteht die Verbindungsstifte in der Keramikplatte einzubringen und/oder die Leiterbahnen durch die Keramikplatte zu den Verbindungsstiften zu bringen. Ein weiterer Nachteil besteht darin, daß wegen der Anordnung und des notwendigen Abstandes der Verbindungsstifte zueinander der Modul von der Grundfläche her erheblich größer ist als dies durch die benötigte und von den Chips eingenommene Grundfläche auf dem Substrat erforderlich ist. Damit wird die Packungsdichte der Chips, die auf einer Einschubkarte unterzubringen sind, nicht von deren Grundfläche sondern von der etwa zehnfach größeren Packungsdichte der Verbindungsstifte bestimmt. Hinzu kommt daß wegen der o.g. Schwierigkeit der Führung der Leiterbahnen im Bereich der mit den Chips belegten Fläche des Substrats eine Anordnung von Verbindungsstiften unmittelbar unterhalb der Chips nicht möglich ist.

Eine Baueinheit bzw. Modul der eingangs genannten Art ist auch aus IBM Technical Disclosure Bulletin Vol. 24, No. 12, S. 6388 f., Mai 1982 bekannt. Bei diesem Modul sind die Chips auf einem Siliziumsubstrat aufgebracht, welches auf einer mechanisch festen Zwischenplatte aufliegt an deren Unterseite die mit den Verbindungsstiften versehene Platte gehalten ist. Zur elektrischen Verbindung der Chips mit den Verbindungsstiften ist ein Mehrleiterkabel vorgesehen, das von an Randbereichen des Siliziumsubstrats angeordneten parallelen Leitern um den seitlichen Randbereich der Zwischenplatte herum und zwischen der Unterseite der Zwischenplatte und der gegenüberliegenden Fläche der Stiftplatte zu den einzelnen die Stiftplatte durchdringenden rückwärtigen Enden der Verbindungsstifte verläuft.

Mit einer derartigen Anordnung der Verbindungsleiter zwischen den Chips und den Verbindungsstiften ist zwar erreicht, daß die Verbindungsleiter nicht mehr in aufwendig herzustellender Weise durch eine Trägerplatte oder dgl. geführt werden müssen und daß auch die Flächenbereiche unterhalb der Chips mit Verbindungsstiften belegt sein können, jedoch besteht nach wie vor ein Mißverhältnis zwischen der für die Chips benötigten Grundfläche und der für die Verbindungsstifte benötigten Grundfläche eines derartigen Moduls. Außerdem sind auch hierbei die einzelnen Bauteile in getrennten Fertigungslinien herzustellen und danach zusammenzubauen.

Ein weiterer Nachteil beider vorgenannten, bekannten Baueinheiten besteht darin, daß sie erst, nachdem die einzelnen Bauteile miteinander verbunden worden sind, getestet werden können, so daß sie, um ggf. kleinere Fehler beheben zu können, nicht wieder unzerstörbar auseinandergenommen werden können. Dies gilt auch im Falle eines späteren Eintritts eines Fehlers in der Baueinheit bzw. in dem Modul.

Aufgabe der vorliegenden Erfindung ist es deshalb, eine elektronische Baueinheit bzw. Modul der eingangs genannten Art zu schaffen, die bzw. der weniger aufwendig in der Herstellung ist und bei gleicher bzw. vergleichbarer Leistungsfähigkeit eine erheblich geringere Grundfläche einnimmt.

Zur Lösung dieser Aufgabe sind bei einer elektronischen Baueinheit bzw. Modul der genannten Art die im Kennzeichen des Anspruchs 1 angegebenen Merkmale vorgesehen.

Durch die erfindungsgemäßen Maßnahmen wird zunächst erreicht, daß die Herstellung dieses Moduls in im wesentlichen einer einzigen Fertigungslinie erfolgen kann, da die Bearbeitung der einzelnen Teile des Moduls in im wesentlichen einer Ebene und an einem einheitlichen bzw. zusammenhängenden Bauteil erfolgen kann. Der Modul ist im Vergleich zu einem bekannten Modul gleicher Leistungsfähigkeit erheblich kleiner d.h. er besitzt eine erheblich kleinere Grundfläche, da es mit den erfindungsgemäßen Merkmalen möglich ist, die für die Verbindungsstifte benötigte Grundfläche im wesentlichen gleich der Chip-Belegungsfläche zu machen, da ja sämtliche Verbindungsstifte im Bereich unterhalb des von den Chips belegten Flächenbereich aufgrund der Umklappbarkeit der Stiftplatten angeordnet werden können. Die Umklappbarkeit der Stiftplatten über bzw. unter das die Chips tragende Substrat bzw. die im Herstellungszustand vorgesehene Anordnung der einzelnen Bauteile in einer einzigen Ebene ermöglicht es, den Modul bereits vor seiner endgültigen Form, die er im umgeklapptem Zustand der Stiftplatten erhält, zu testen und mögliche Fehler in bspw. den elektrischen Verbindungen sofort zu reparieren.

Mit den Merkmalen des Anspruchs 2 ist erreicht, daß die durch das Substrat vorgegebene Grundfläche in optimaler Weise mit Verbindungsstiften belegt werden kann.

Entsprechendes gilt bei einem mit den Merkmalen des Anspruchs 3 ausgeführten Ausführungsbeispieles, wobei gleichzeitig auch die Verbindungsmöglichkeiten über die mit den Leitern versehenen Verbindungselemente optimiert sind.

Eine besonders optimale Ausführungsform auch im Hinblick auf bestehende Anordnungen und Abmessungen von Steckkarten und dgl. ergibt sich mit den Merkmalen des Anspruchs 4. Eine besonders günstige und für die Chips Schutz bietende Anordnung ergibt sich durch die Merkmale des Anspruchs 5.

Zweckmäßig ist es, wenn die Merkmale des Anspruchs 6 vorgesehen sind, da dann eine einfache und lösbare Möglichkeit der Verbindung und Halterung der Stiftplatten am Substrat möglich ist. Mechanisch stabile und einfache Ausführungsbeispiele können durch die Merkmale der Ansprüche 7 und/oder 8 und/oder 9 verwirklicht sein. Von Vorteil ist hierbei außerdem, daß der Modul, ohne daß er zerstört werden muß, für bspw. notwendige Reperaturarbeiten in seinen Ausgangszustand, den er bei und nach der Herstellung inne hatte, zurückgeführt werden kann.

Mit den Merkmalen des Anspruchs 10 ist zur Reduzierung der Bauhöhe ein unmittelbares aneinander Anliegen von Stiftplatte und Bodenplatte erreicht. Dabei ist es zweckmäßig, für eine Ausgestaltung der Druckknopfverbindung die Merkmale des Anspruchs 11 vorzusehen, so daß derjenige bzw. diejenigen Stifte, die der Druckknopfverbindung dienen, gleichzeitig als Verbindungsstift Verwendung finden.

Bevorzugte Ausführungsbeispiele hinsichtlich der bei den einzelnen Bauteilen verwendeten Materialien ergeben sich aus den Merkmalen des Anspruchs 12, 13, 14 bzw. 15.

Um die Baueinheit bzw. den Modul ausreichend kühlen zu können, sind zweckmäßigerweise die Merkmale des Anspruchs 16 und/oder die des Anspruchs 17 vorgesehen.

Mit den Merkmalen des Anspruchs 18 ist erreicht, daß das Substrat erstens als Abschirmung der Leiterbahnen auf dem Kunststoff, zweitens als Stromverteilung für die Chips und drittens als Entkopplung durch im Substrat eingebaute Entkoppelkondensatoren dienen kann. Außerdem ist dies eine optimale Ausführung hinsichtlich Herstellung und Kosten.

Weitere Einzelheiten der Erfindung sind der folgenden Beschreibung zu entnehmen, in der die Erfindung anhand des in der Zeichnung dargestellten Ausführungsbeispieles näher beschrieben und erläutert ist. Es zeigen:

Figur 1 eine Unteransicht eines Moduls in einem offenen, großflächigen Ausgangszustand unmittelbar nach Fertigstellung gemäß einem bevorzugten Ausführungsbeispiel vorliegender Erfindung und

Figur 2 einen Schnitt längs der Linie II-II der Fig. 1, wobei der Modul im rechten Teil in seinem offenen Ausgangszustand und im linken Teil in seinem durch eine Einklappbewegung und durch Hinzufügen zweier mechanisch relevanter Bauteile erreichten Endzustand dargestellt ist.

Der elektronische Baustein 11, der im folgenden als Modul bezeichnet wird, besitzt ein Substrat 12, auf dem mehrere integrierte Schaltkreise aufweisende Chips 13 in Flip-Chip-Weise aufgebracht sind. Beim dargestellten Ausführungsbeispiel ist das Substrat 12, das den Chipträger darstellt, eine Siliziumplatte quadratischer Form. Das Substrat 12 ist mit einer Vielzahl von bspw. gedruckten nicht dargestellten Leiterbahnen versehen, die über die den Chips 13 zugewandte Fläche des Substrats 12 entsprechend verteilt angeordnet und zu jedem der Randbereiche 16 bis 19 des Substrats 12 führen. Die Chips 13 sind in Flip-Chip-Weise mittels nicht dargestellter Lötkugeln mit den nicht dargestellten entsprechenden Leiterbahnen auf dem Substrat 12 elektrisch und mechanisch verbunden. Beim dargestellten Ausführungsbeispiel sind 3 mal 3 im Abstand voneinander angeordnete Chips 13 auf dem Substrat 12 vorgesehen.

In nicht dargestellter Weise kann das Substrat 12 eine leiterbahnpersonalisierte, d.h. bzgl. der Leiterbahnen individualisierte Chips aufnehmende Platte sein.

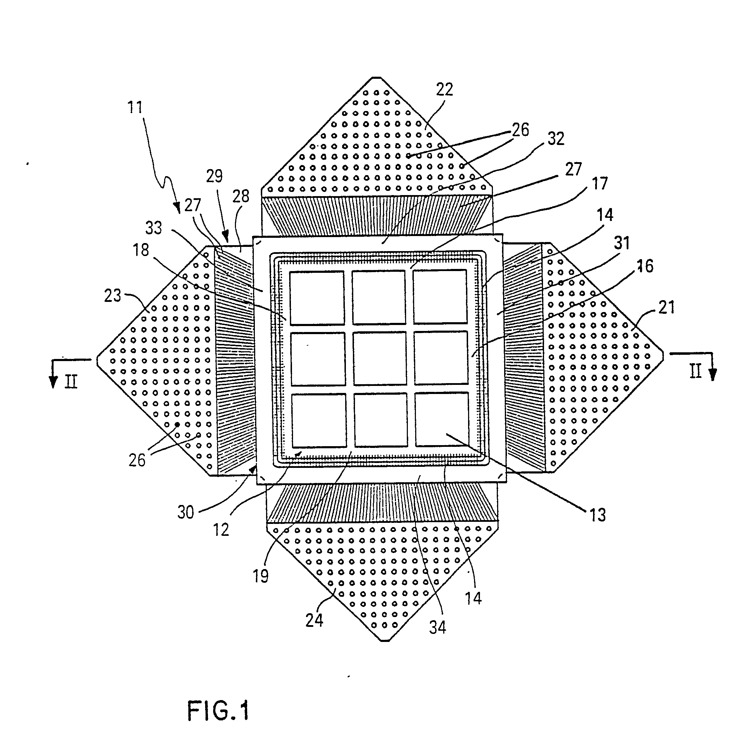

Gegenüber jedem der Randbereiche 16 bis 19 (siehe Fig. 1) ist eine Stiftplatte 21 bis 24 in einem Abstand vorgesehen, die mit einer Vielzahl von über die Gesamtfläche im wesentlichen gleichmäßig verteilt angeordneten Verbindungsstiften 26 versehen sind. Die Stiftplatten 21 bis 24 sind aus einem elektrisch isolierenden Material, bspw. aus einem Kunststoff und sind mechanisch im wesentlichen starr ausgebildet. Jede der Stiftplatten 21 bis 24 ist mit dem jeweils gegenüberliegenden Randbereich 16 bis 19 des Substrats 12 über ein mit elektrischen Leitern 27 und einem flexiblen Träger 28 versehenes Verbindungselement 29 verbunden. Die im flexiblen Träger 28 elektrisch voneinander isoliert angeordneten Leiter 27 sind einenends bei 14 mit den entsprechenden Leiterbahnen des Substrats 12 bspw. durch Thermokompression und andernends in ebenfalls nicht dargestellter Weise mit jeweils einem der Verbindungsstifte 26 elektrisch verbunden. Auf diese Weise ergibt sich zwischen den Stiftplatten 21 bis 24 und den auf dem Substrat 12 angeordneten Chips 13 eine elektrische Verbindung, die mechanisch gesehen flexibel ausgebildet ist.

Gemäß einer nicht dargestellten Variante ist es möglich, die Stiftplatte 21 - 24 oder -platten und das oder die Verbindungselemente 29 bzw. deren flexibler Träger 28 mit einer isolierte Leiterbahnen enthaltenden Kunststoffschicht des Substrats 12 als eine Einheit auszubilden, wobei diese Einheit im Bereich des Substrats 12 auf ihrer einen Seite die Chips 13 aufnimmt und auf der anderen Seite mit dem Substrat eine elektrische Verbindung eingeht.

Beim Ausführungsbeispiel sind die Stiftplatten 21 bis 24 untereinander gleich ausgebildet und besitzen eine Dreieckform, deren Gesamtgrundfläche etwa der Grundfläche des Substrats 12 entspricht. Mit anderen Worten, die aneinandergesetzen dreieckförmigen Stiftplatten 21-24 ergeben ein der Grundfläche des Substrats 12 entsprechendes Quadrat. Die mechanisch flexible und elektrische Verbindung zwischen den Stiftplatten und dem Substrat 12 erfolgt beim dargestellten Ausführungsbeispiel durch ein flaches bandförmiges Kabel. Es versteht sich, daß auch andere elektrisch leitende und mechanisch flexible Verbindungen vorgesehen sein können.

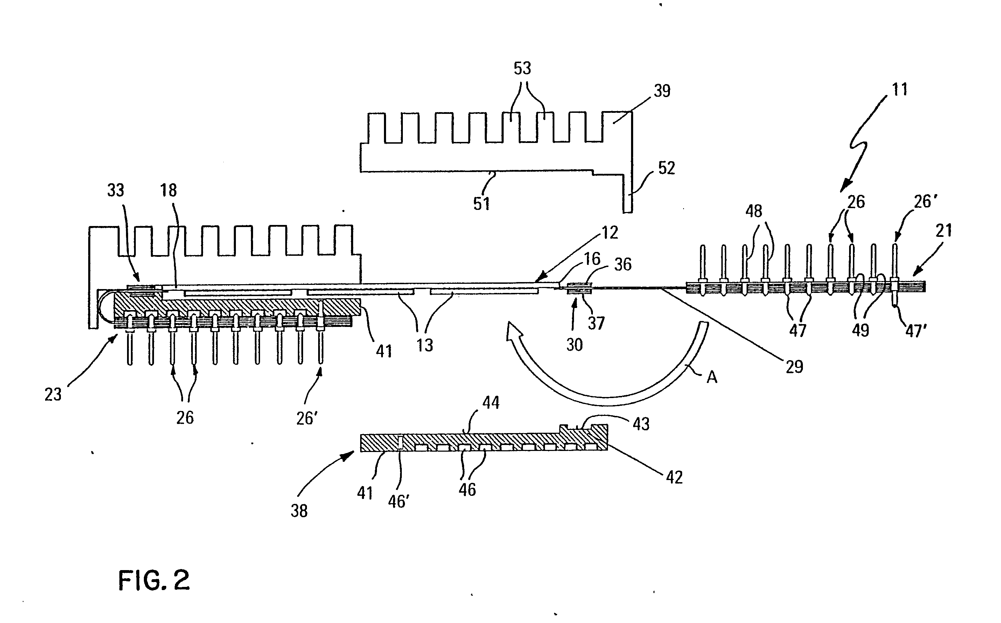

In dem in Fig. 1 und im rechten Teil der Fig. 2 dargestellten offenen Ausgangszustand wird der Modul 11 aus seinen einzelnen Bauteilen zusammengesetzt bzw. werden die Modul-Bauteile entsprechend bestückt. In diesem Ausgangszustand sind die Stiftplatten 21 bis 24 etwa in einer Ebene mit dem Substrat 12.

Gemäß Fig. 1 ist ferner ein Zugentlastungsrahmen 31 vorgesehen, dessen einzelne Rahmenschenkel 31 - 34 aus einem oberen und unteren Steg 36, 37 bestehen, zwischen denen das jeweilige Verbindungselement 29 klemmend gehalten ist. Der Zugentlastungsrahmen 30 ist in einem konstanten jedoch geringen Abstand um das Substrat 12 umlaufend angeordnet.

Gemäß Fig. 2 wird nun der Modul 11 mit Hilfe zweier weiterer Bauteile 38 und 39 aus seinem rechts dargestellten offenen Ausgangszustand in einen links dargestellten Endzustand dadurch gebracht, daß die Stiftplatten 21 bis 24 gemäß Fig. 1 nach oben bzw. gemäß Fig. 2 nach unten (entspr. Pfeil A) über bzw. unter das Substrat 12 geklappt werden.

Das Bauteil 38 ist durch eine Bodenplatte 41 gebildet, die ein- oder mehrteilig, quadratisch oder dreieckförmig sein kann. Die Bodenplatte 41 besitzt an einem äußeren Randbereich 42 eine Nut 43, in die der untere Steg 37 des betreffenden Schenkels 31 bis 34 des Zugentlastungsrahmens 30 passend einlegbar ist. Die Bodenplatte 41 besitzt außerdem vom Randbereich 42 radial nach innen verlaufend eine Vertiefung 44, in welcher die auf dem Substrat 12 angeordneten Chips 13 dann aufgenommen sind, wenn der Zugentlastungsrahmen 30 auf der Bodenplatte 41 aufliegt und die Bodenplatte 41 von dem Substrat 12 sozusagen überspannt ist. Die Bodenplatte 41 besitzt der Vertiefung 44 und der Nut 43 abgewandt eine Vielzahl von Sacklochbohrungen 46, in denen diejenigen Enden 47 der Verbindungsstifte 26 aufgenommen sind, die die Stiftplatte 21 bis 24 rückseitig etwas überragen. Die von der Stiftplatte 21 bis 24 im Endzustand herausragenden Enden 48 der Verbindungsstifte 26, die zwischen den beiden Enden 47 und 48 einen Ringrand 49 besitzen, sind wesentlich länger als die die Stiftplatte durchdringenden hinteren Enden 47. Einer der Verbindungsstifte 26′, der vorzugsweise im Bereich der Ecken jeder Stiftplatte 21 bis 24 angeordnet ist, besitzt ein verlängertes hinteres Ende 46′, das in umgeklapptem Endzustand der Stiftplatte 21 bis 24 in eine durchmesserkleinere durchgehende Bohrung 46′ in der Bodenplatte 41 ragt. Dabei sind die Durchmesser-Abmessungen des Stiftendes 47′ und der durchgehenden Bohrung 46′ derart, daß sich in ineinandergestecktem Zustand eine Art lösbare Durckknopfverbindung ergibt. Auf diese Weise läßt sich jede Stiftplatte 21 bis 24 mit der Bodenplatte 38 lösbar verriegeln, wobei die Rückseite der Stiftplatte 21 bis 24 unmittelbar an der Unterseite der Bodenplatte 38 anliegt.

Die Bodenplatte 41 dient als Positionierung der Stiftplatten 21 bis 24 und dazu, daß alle Stifte 26 zueinander im richtigen Rasterabstand angeordnet sind, damit der Modul 1 1 von der nächsten Packungs-Baugruppe, wie bspw. einer Karte aufgenommen werden kann.

Wie aus dem linken Teil der Fig. 2 ersichtlich ist, ist die Länge der Verbindungselemente 29 zwischen Stiftplatte 21 bis 24 und Substrat 12 gerade so gewählt, daß die Stiftplatte 21 bis 24 in bequemer Weise um die Bodenplatte 38 nach unterhalb des Substrats 12 geklappt werden kann. Dies erfolgt um alle vier Randbereiche der Bodenplatte 38, so daß unterhalb des Substrats 12 die Verbindungsstifte 26 über eine Fläche verteilt vorragen, die derjenigen Fläche etwa entspricht, die als Belegungsfläche für die Chips 13 auf dem Substrat 12 zur Verfügung steht.

Das Bauteil 39 ist ein Kühlkörper, der mit seiner entsprechend geformten Innenfläche 51 auf den Zugentlastungsrahmen 30, die Bodenplatte 38 und das Substrat 12 aufgebracht wird und der mit einem umlaufenden Schutzsteg 52 die Verbindungselemente 29 überdeckt. Der Kühlkörper 39 ist in nicht dargestellter Weise mit dem Bauteil 38 fest verbunden. Der Kühlkörper 39, der außenseitig mit Kühlrippen 53 versehen ist, ist einstückig. Mit ihm ist eine Zugentlastung für die flexiblen Verbindungselemente 29 und ein mechanischer Schutz für das Substrat 12 gegeben. Der Kühlkörper 39 kann aus mehreren Teilen bestehen, wobei das dem Substrat 12 zugewandte Teil als ein Stück mit der Größe und Fläche des Substrates 12 aus den vorher genannten Gründen sein soll.

Es versteht sich, daß auch die Bodenplatte 41 und/oder die Verbindungsstifte 26 als Kühlkörper wirken können.

Ferner ist es möglich, die Stiftplatten 21 bis 24 gemäß Fig. 2 nach oben umzuklappen, wobei die längeren Stiftteile 48 immer nach außen aus dem Modul 11 herausragen.

Wenn auch in der Zeichnung gemäß einem bevorzugten Ausführungsbeispiel ein Substrat 12 dargestellt ist, das quadratisch ausgebildet ist, versteht es sich, daß das Substrat 12 die Form eines beliebigen Vieleckes aufweisen kann. In diesem Falle kann die vieleckige Substrat-Fläche für die Formgebung der Stiftplatten 21 bis 24 in beliebige mehreckige (mit entsprechend geringerer Anzahl von Ecken) Einzelflächen aufgeteilt sein, die zusammengesetzt, also in umgeklapptem Endzustand, sich zu dem betreffenden Vieleck des Substrats 12 ergänzen. Bevorzugt ist dabei jedem vorzugsweise geradlinigen Randbereich des Substrats 12 jeweils eine Stiftplatte 21 zugeordnet, welche Stiftplatten 21 dann jeweils eine Dreieckform, ggf. teilweise unterschiedlicher Größe, aufweisen.

## Ansprüche

1. Elektronische Baueinheit, mit einem Substrat, auf dem vorzugsweise mehrere ggf. elektrisch miteinander verbundene Chips angeordnet sind, und mit einer Vielzahl von Verbindungsstiften, die an einer Stiftplatte gehalten und über Leiter mit den Chips elektrisch verbunden sind, **dadurch gekennzeichnet,** daß mehrere mit Verbindungsstiften (26) versehene Stiftplatten (21 -24) vorgesehen sind, von denen jede mittels mindestens eines mit den Leitern versehenen, flexiblen Verbindungselementes (29) an einem Randbereich (16-19) des eine Grundfläche in Form eines beliebigen Vielecks aufweisenden Substrats (12) derart gehalten ist, daß sie aus einer mit der Ebene des Substrats (12) im wesentlichen fluchtenden Ebene in eine Position oberhalb und/oder unterhalb des Substrats (12) bzw. umgekehrt klappbar ist.

2. Baueinheit nach Anspruch 1, dadurch gekennzeichnet, daß die Gesamtgrundfläche aller Stiftplatten (21-24) im wesentlichen gleich derjenigen des Substrats (12) ist.

3. Baueinheit nach Anspruch 1 oder 2, dadurch gekennzeichnet, daß die Anzahl der Stiftplatten (21-24) gleich der Anzahl der Ecken bzw. der Randbereiche (16-19) des vieleckigen Substrats (12) ist.

4. Baueinheit nach einem der Ansprüche 1-3, dadurch gekennzeichnet, daß das Substrat (12) rechteckförmig, vorzugsweise quadratisch und jede der Stiftplatten (21-24) dreieckförmig, vorzugsweise gleichschenklig dreieckförmig ist.

5. Baueinheit nach einem der vorhergehenden Ansprüche, dadurch gekennzeichnet, daß die Stiftplatte (21-24) gegenüber derjenigen Fläche des Substrats (12) umgeklappt angeordnet ist, auf der die Chips (13) gehalten sind.

6. Baueinheit nach einem der vorhergehenden Ansprüche, dadurch gekennzeichnet, daß die Stiftplatte (21-24) in umgeklapptem Zustand gegenüber dem Substrat (12) verriegelt gehalten ist.

7. Baueinheit nach einem der vorhergehenden Ansprüche, dadurch gekennzeichnet, daß das Substrat (12) in eine Vertiefung (44) einer Bodenplatte (38) eingelegt ist.

8. Baueinheit nach Anspruch 7, dadurch gekennzeichnet, daß das Substrat (12) mittels an den Verbindungselementen (29) angreifender Zugentlastungselemente (30-34) auf der Bodenplatte (38) und/oder einer Deckplatte, vorzugsweise dem Kühlkörper (39) gehalten ist.

9. Baueinheit nach Anspruch 6 und 7, dadurch gekennzeichnet, daß die Stiftplatte (21-24) mit der Bodenplatte (38) mittels einer Art Druckknopfverbindung (46´,47´) lösbar verriegelbar ist.

10. Baueinheit nach einem der Ansprüche 7-9, dadurch gekennzeichnet, daß die Bodenplatte (38) Ausnehmungen (46) zur Aufnahme der die Stiftplatte (21 -24) durchdringenden rückseitigen Enden (47) der Verbindungsstifte (26) aufweist.

11. Baueinheit nach den Ansprüchen 9 und 10, dadurch gekennzeichnet, daß mindestens ein zusammengehörendes Paar von Verbindungsstiftende (47´) an der Stiftplatte (21-24) und Ausnehmung (46´) in der Bodenplatte (38) die Druckknopfverbindung bildet.

12. Baueinheit nach einem der vorhergehenden Ansprüche, dadurch gekennzeichnet, daß das Substrat (12) eine Siliziumplatte ist.

13. Baueinheit nach einem der vorhergehenden Ansprüche, dadurch gekennzeichnet, daß das Substrat (12) eine leiterbahnpersonalisierte Chips aufnehmende Platte ist.

14. Baueinheit nach einem der vorhergehenden Ansprüche, dadurch gekennzeichnet, daß das Verbindungselement (29) ein mit Leiterbahnen (27) bestückter vorzugsweise flachbandförmiger flexibler Kunststoffträger (28) ist.

15. Baueinheit nach einem der vorhergehenden Ansprüche, dadurch gekennzeichnet, daß die Stiftplatte (21-24) die Stifte gegenseitig isoliert in Kunststoff eingebettet hält.

16. Baueinheit nach einem der vorhergehenden Ansprüche, dadurch gekennzeichnet, daß die Stiftplatte (21-24) und/oder die Verbindungsstifte (26) einen Kühlkörper bilden.

17. Baueinheit nach einem der Ansprüche 7-16, dadurch gekennzeichnet, daß das Substrat (12) auf der der Bodenplatte (38) gegenüberliegenden Fläche von einem Kühlkörper (39) abgedeckt ist.

18. Baueinheit nach einem der Ansprüche 2-11 oder 13 - 17, dadurch gekennzeichnet, daß die Stiftplatten (21-24) und die Verbindungselemente (29) mit der isolierte Leiterbahnen enthaltende Kunststoffoberfläche des Substrats (12) eine Einheit bilden, die im Bereich des Substrats (12) auf der einen Seite die Chips (13) aufnimmt und auf der anderen Seite das Substrat (12) elektrisch kontaktiert.

FIG.1

EP 0 351 531 A2

FIG. 2